# EUROPEAN PATENT APPLICATION

(11) **EP 4 730 950 A1**
(43) Date of publication of application: **22.04.2026**
(21) Application number: 25208764.8
(22) Date of filing: 15.10.2025
(51) Int. Cl.: H10D 30/01, H10D 30/65, H10D 62/13, H10D 64/00, H10D 64/20, H10D 64/27, H10D 30/66

(54) **POWER SEMICONDUCTOR DEVICE AND METHOD FOR MANUFACTURING SAME**

(30) Priority: 18.10.2024 CN 202411463012
(71) Applicant: Silergy Semiconductor Technology (Hangzhou) Co., Ltd., Hangzhou City, Zhejiang Province 310051 (CN)
(72) Inventor: YU, Hui, Hangzhou City, Zhejiang Province, 310051 (CN); CAI, Jun, Hangzhou City, Zhejiang Province, 310051 (CN)
(74) Representative: Viering, Jentschura & Partner mbB Patent- und Rechtsanwälte

(57) **Abstract**

A power semiconductor device and a method for manufacturing the power semiconductor device are disclosed. The power semiconductor device comprises a substrate (100), a main gate (210), and an insulating layer (230). The substrate (100) comprises an active region (110), the active region (110) comprises a source region (111) and a drain region (112). A gate trench (113) is formed between the source region (111) and the drain region (112) and is recessed from the upper surface of the substrate (100) to the active region (110). The main gate (210) is located in the gate trench (113), and the main gate (210) extends downward from an upper surface of the gate trench (113). The insulating layer (230) is formed between an inner wall of the gate trench (113) and the main gate. Compared to conventional power semiconductor devices, the drift region length is transformed from the lateral spacing between the source and drain regions to the perimeter of the gate trench. This structural shift reduces the device's lateral dimension while maintaining the target BV, lowering the specific on-resistance (Rsp), thereby resulting in an improved BV-to-Rsp trade-off and enabling a more compact device design.

## Description

### FIELD OF THE INVENTION

The present disclosure relates to the technical field of semiconductor devices, and in particular, to a power semiconductor device and a method for manufacturing the power semiconductor device.

### BACKGROUND OF THE INVENTION

Power semiconductor devices, also referred to as power electronic components, are high-power electronic units primarily utilized in electrical equipment for energy conversion and control circuitry. In applications that demand high current and high-frequency switching, it's essential to adopt devices with low gate charge (Qg) and strong robustness to ensure high efficiency in compact designs.

Typically, these devices feature a source, a drain, and a main gate electrode, with the main gate positioned between the source and drain. When a voltage is applied to the main gate, it enables conduction between the source and drain electrodes.

However, to meet the required breakdown voltage (BV), the source and drain must be spaced a certain distance apart, which imposes limits on how much the overall device size can be scaled down.

### SUMMARY OF THE INVENTION

The present disclosure provides a power semiconductor device and a method for manufacturing the power semiconductor device.

A first embodiment of the present disclosure provides a power semiconductor device, which comprises a substrate, a main gate, and an insulating layer.

The substrate comprises an active region, the active region comprises a source region and a drain region, both of which are of a first doping type and extend from an upper surface of the substrate into its interior. A gate trench is formed between the source region and the drain region and is recessed from the upper surface of the substrate to the active region.

The main gate is located in the gate trench, and the main gate extends downward from an upper surface of the gate trench.

The insulating layer is formed between an inner wall of the gate trench and the main gate.

In some examples of the present disclosure, the main gate is arranged at a location closer to the source region than to the drain region.

In some examples of the present disclosure, the power semiconductor device further comprises a source and a drain.

The source is disposed on the upper surface of the substrate and electrically connected to the source region.

The drain is disposed on the upper surface of the substrate and electrically connected to the drain region.

In some examples of the present disclosure, the power semiconductor device further comprises at least one shielding gate disposed in the gate trench.

The shielding gate is disposed below the main gate, and the shielding gate and the main gate are spaced apart.

The shielding gate is disposed at a side of the main gate closer to the drain region.

In some examples of the present disclosure, the inner wall of the gate trench comprises a first inner wall positioned closer to the source region and a second inner wall positioned closer to the drain region, and the shielding gate is spaced apart from the first inner wall by a first spacing, and spaced apart from the second inner wall by a second spacing.

The first spacing is basically equal to the second spacing.

In some examples of the present disclosure, the power semiconductor device comprises two or more shielding gates, and the shielding gates are arranged at intervals along a thickness direction of the substrate.

In some examples of the present disclosure, the active region further comprises a first doped region of the first doping type, and the first doped region surrounds sidewalls and a bottom of the gate trench.

In some examples of the present disclosure, the active region further comprises a second doped region of a second doping type, and the second doped region surrounds a sidewall and a bottom of the first doped region.

In some examples of the present disclosure, the active region further comprises a heavily doped buffer region of the first doping type, the heavily doped buffer region is located at a bottom of the drain region, and an ion doping concentration of the heavily doped buffer region is lower than an ion doping concentration of the drain region.

In some examples of the present disclosure, the active region further comprises a body region of a second doping type, the body region is located at a bottom of the source region, and a side edge of the body region and a side edge of the source region constitute part of the first inner wall of the gate trench.

In some examples of the present disclosure, a cross section of the gate trench is U-shaped, rectangular, or trapezoidal.

A second embodiment of the present disclosure provides a method for manufacturing a power semiconductor device, comprising providing a substrate; forming an active region in the substrate; recessing an upper surface of the substrate to the active region to form a gate trench; filling the gate trench to form an insulating layer; forming a main gate in the insulating layer, where the main gate extends from an upper surface of the gate trench into an interior of the gate trench; and forming a source region and a drain region extending from an upper surface of the active region into its interior, where the gate trench is disposed between the source region and the drain region.

In some examples of the present disclosure, before forming the main gate in the insulating layer, the method further comprises: forming at least one shielding gate in the insulating layer.

The shielding gate is disposed below the main gate, and the shielding gate and the main gate are spaced apart.

The shielding gate is disposed at a side of the main gate closer to the drain region.

In some examples of the present disclosure, the main gate is arranged at a location closer to the source region than to the drain region.

In some examples of the present disclosure, the method further comprises: forming a source on the upper surface of the substrate, where the source is electrically connected to the source region; and forming a drain on the upper surface of the substrate, where the drain is electrically connected to the drain region.

In some examples of the present disclosure, after forming the gate trench and before forming the source region and the drain region, the method further comprises: forming a first doped region in the active region. The first doped region surrounds sidewalls and a bottom of the gate trench, and an ion doping concentration of the first doped region is greater than an ion doping concentration of the active region. The active region is of a first doping type.

In some examples of the present disclosure, before forming the first doped region, the method further comprises: forming a second doped region in the active region.

The second doped region surrounds a sidewall and a bottom of the first doped region. Doping types of the first doped region and the second doped region are different.

In some examples of the present disclosure, the method further comprises: forming a heavily doped buffer region in the active region. An ion doping concentration of the heavily doped buffer region is lower than an ion doping concentration of the drain region, and the drain region is disposed in the heavily doped buffer region.

In some examples of the present disclosure, the method further comprises: forming a body region in the active region. The body region is located at a bottom of the source region, and a side edge of the body region and a side edge of the source region constitute part of a first inner wall of the gate trench positioned closer to the source region.

In some examples of the present disclosure, the body region is formed by ion implantation or ion implantation heating diffusion, and a gate-to-source charge of the power semiconductor device is reduced by adjusting a depth of the body region disposed below the source region.

The presently disclosed power semiconductor device achieves enhanced voltage withstand capability through the use of a thick insulating layer; specifically, the power semiconductor device includes a substrate, a main gate, and an insulating layer, with a gate trench recessed between the source and drain regions on the substrate, wherein the main gate is positioned within the trench so that it extends downward from the trench's upper surface, and wherein an insulating layer is located between the trench's inner wall and the main gate. Compared to conventional power semiconductor devices, the drift region length is transformed from the lateral spacing between the source and drain regions to the perimeter of the gate trench. This structural shift reduces the device's lateral dimension while maintaining the target BV, lowering the specific on-resistance (Rsp), thereby resulting in an improved BV-to-Rsp trade-off and enabling a more compact device design.

### BRIEF DESCRIPTION OF DRAWINGS

In order to more clearly illustrate the technical solutions in the embodiments of the present disclosure, the following is a brief description of the accompanying drawings to be used in the description of the embodiments. It is obvious that the following description of the accompanying drawings is only about embodiments of the present invention. For the person of ordinary skill in the art, other drawings can be obtained without creative work, according to these accompanying drawings.
FIG. 1 is a schematic structural diagram showing a cross-section of a current power semiconductor device.
FIG. 2 is a schematic diagram showing an electric field distribution of the power semiconductor device shown in FIG. 1.
FIG. 3 is a first schematic structural diagram showing a cross-section of a power semiconductor device according to an embodiment of the present disclosure.
FIG. 4 is a schematic diagram showing an electric field distribution of the power semiconductor device shown in FIG. 3.
FIG. 5 is a second schematic structural diagram showing a cross-section of a power semiconductor device according to an embodiment of the present disclosure.
FIG. 6 is a third schematic structural diagram showing a cross-section of a power semiconductor device according to an embodiment of the present disclosure.
FIG. 7 is a fourth schematic structural diagram showing a cross-section of a power semiconductor device according to an embodiment of the present disclosure.
FIG. 8 is a fifth schematic structural diagram showing a cross-section of a power semiconductor device according to an embodiment of the present disclosure.
FIG. 9 is a sixth schematic structural diagram showing a cross-section of a power semiconductor device according to an embodiment of the present disclosure.
FIG. 10 is a seventh schematic structural diagram showing a cross-section of a power semiconductor device according to an embodiment of the present disclosure.
FIG. 11 is an eighth schematic structural diagram showing a cross-section of a power semiconductor device according to an embodiment of the present disclosure.
FIG. 12 is a ninth schematic structural diagram showing a cross-section of a power semiconductor device according to an embodiment of the present disclosure.

### Reference numerals

100 - Substrate; 110 - Active Region; 111 - Source Region; 112 - Drain Region; 113 - Gate Trench; 114 - First Doped Region; 115 - Second Doped Region; 116 - Heavily Doped Buffer Region; 117 - Body Region; 118 - Body Contact Region; 210 - Main Gate; 220 - Shielding Gate; 230 - Insulating Layer; 300 - Source; 400 - Drain.

### DETAILED DESCRIPTION OF THE INVENTION

In order to make the inventive purpose, technical solutions and beneficial technical effects of the present disclosure clearer, the technical solutions in the embodiments of the present disclosure will be described clearly and completely below with reference to the drawings. In the drawings, the same or similar reference numerals refer to the same or similar components or components with the same or similar functions throughout. The described embodiments are just a part but not all of the embodiments of the present disclosure. The embodiments described below with reference to the accompanying drawings are exemplary and are intended to explain the present disclosure and should not be interpreted as restricting the present disclosure. All other embodiments that persons of ordinary skill in the art obtain without creative efforts based on the embodiments of the present disclosure also fall within the scope of the present disclosure. The present disclosure will be described in further detail below with reference to the accompanying drawings.

In the present disclosure, unless otherwise expressly specified, terms such as "installation," "connection," and "coupling" should be broadly understood. For example, when one element is referred to as being "connected to" another element, one element may be fixedly connected to or detachably connected to another element, may be integrally connected to another element, may be mechanically connected to or electrically connected to another element, may be directly connected to another element, or may be indirectly connected to another element with another element interposed therebetween. These two elements may also communicate with each other internally or interact with each other. Those of ordinary skill in the art can understand the specific meanings of the above terms in the present disclosure according to specific situations.

It should be noted that terms such as "up," "down," "front," "back," "vertical," "horizontal," "top," "bottom," "inside," and "outside" indicate the orientation or position relationship based on those shown in the accompanying drawings. It is only for the convenience of describing and simplifying the description, and does not indicate or imply that the device or component mentioned must have a specific orientation, be constructed and operated in a specific orientation, and cannot be construed as restricting the present disclosure.

The terms "first," "second," "third," "fourth," and the like, as used in the specification and claims of the present disclosure, serve to distinguish similar objects without necessarily implying a specific order or sequence.

In addition, the terms "comprise" and "include" as used in the specification and claims are intended to be non-exclusive. For example, a process, method, system, or product that comprises a series of steps or elements is not limited to only those explicitly listed, but may also include other steps or elements that are not expressly stated or that are inherent to the process, method, system, or product.

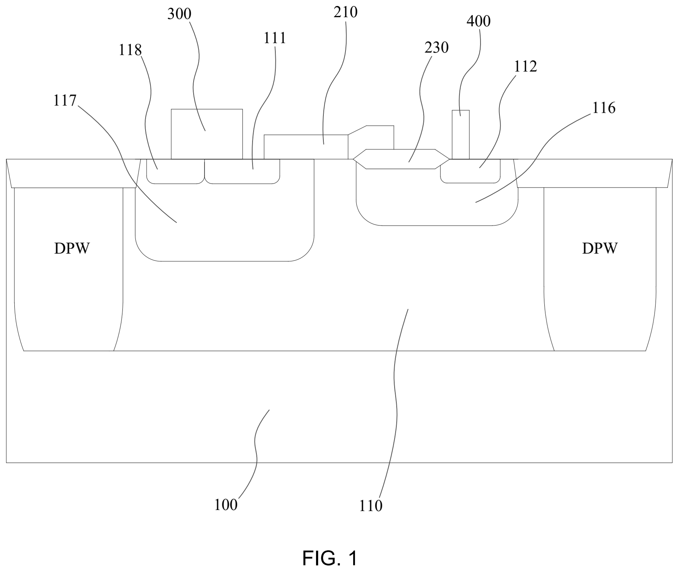

As shown in FIG. 1, a traditional power semiconductor device includes a source (also referred to as source electrode) 300, a drain (also referred to as drain electrode) 400, and a main gate (also referred to as main gate electrode) 210 respectively disposed on a substrate 100 (bulk silicon), with the main gate electrode 210 located between the source electrode 300 and the drain electrode 400. The source electrode 300 is electrically connected to a source region 111 formed in the substrate 100, and the drain electrode 400 is electrically connected to a drain region 112 formed in the substrate. A lateral drift region is formed between the source region 111 and the drain region 112. When a voltage is applied to the main gate electrode 210, it enables conduction between the source electrode 300 and the drain electrode 400. Power semiconductor devices must address requirements across analog, low-voltage digital, and high-voltage power domains. For analog applications, it is essential to develop devices with enhanced analog precision. Digital Complementary Metal-Oxide-Semiconductor (CMOS) scaling has benefited from advances in lithography. However, from the perspective of process node scaling, lateral high-voltage (HV) and power devices are constrained by lateral geometry scaling under constant electric field conditions. This constraint implies that, at a target BV, the power semiconductor device is limited by the peak electric field in bulk silicon, preventing size reduction in line with advanced process nodes.

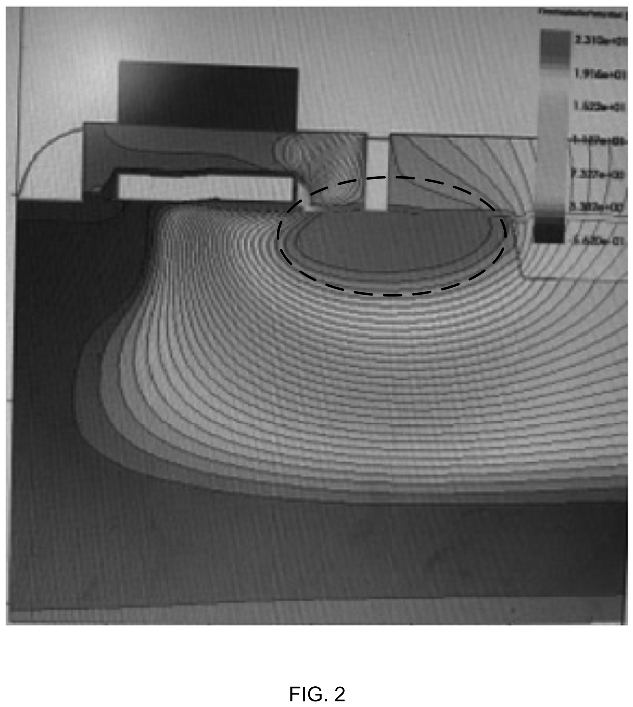

As illustrated in FIG. 2, the length of the lateral drift region in the traditional power semiconductor device is relatively short, the electric field reaches its maximum in the drain region of the bulk silicon (the region enclosed by the dashed lines), resulting in a lower breakdown voltage (BV) of the device and an increased risk of electrical breakdown.

Extensive analysis and validation by the inventors reveal that forming a gate trench in the substrate, positioning the main gate electrode within the trench rather than on the substrate surface, and filling the gate trench to form a thick insulating layer (such as an oxide layer), which exhibits a higher peak electric field than bulk silicon, can significantly enhance the device's voltage withstand capability. Compared to conventional power semiconductor devices, the drift region length is transformed from the lateral spacing between the source and drain regions to the perimeter of the gate trench. This structural reduces the device's lateral dimension while maintaining the target breakdown voltage.

In view of this, a novel power semiconductor device and a corresponding manufacturing method are provided. The gate trench is formed in the substrate, and the main gate electrode is embedded within the gate trench, extending downward from the upper surface of the gate trench. The remaining volume of the gate trench is filled to form the insulating layer. By leveraging the high peak electric field of the insulating layer, the device achieves improved breakdown performance. The drift region length is limited by the trench perimeter rather than lateral spacing between the source and drain regions, thereby reducing the lateral footprint of the drift region at a given BV, resulting in a more compact device structure and lower Specific On-Resistance (Rsp).

The following detailed description, in conjunction with the accompanying drawings, presents the technical solutions of the proposed power semiconductor device and its manufacturing method.

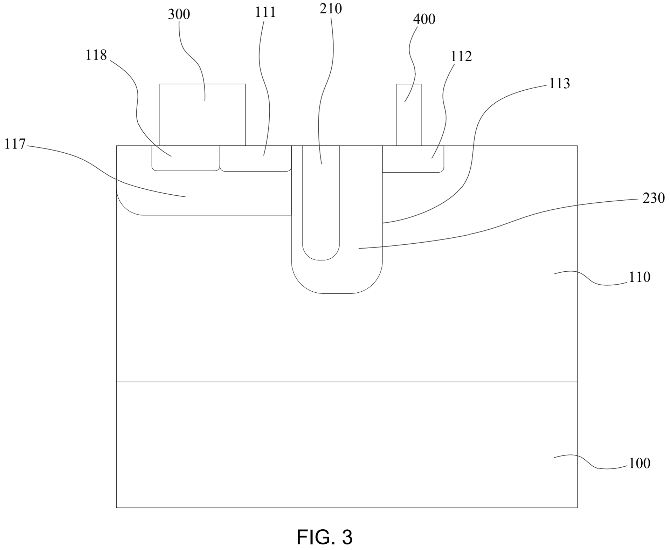

Referring to FIGs. 3 to 8, the present disclosure provides a power semiconductor device, and the power semiconductor device includes a substrate 100, a main gate 210, and an insulating layer 230. The substrate 100 comprises an active region 110, the active region 110 comprises a source region 111 and a drain region 112, both of which are of a first doping type and extend from an upper surface of the substrate 100 into its interior. A gate trench 113 is formed between the source region 111 and the drain region 112 and is recessed from the upper surface of the substrate 100 to the active region 110. The main gate 210 is located in the gate trench 113, and the main gate 210 extends downward from an upper surface of the gate trench 113. The insulating layer 230 is formed between an inner wall of the gate trench 113 and the main gate 210.

The power semiconductor device may be a Lateral Diffused Metal Oxide Semiconductor (LDMOS), such as an NLDMOS or a PLDMOS. The source region 111 and the drain region 112 have the same ion doping type. As an example, when the power semiconductor device is an NLDMOS, N-type impurities are doped in the source region 111 and the drain region 112 respectively; and when the power semiconductor device is a PLDMOS, P-type impurities are doped in the source region 111 and the drain region 112 respectively.

The following description uses an NLDMOS power semiconductor device as an example for illustration purposes only and should not be construed as restricting the scope of the present disclosure.

As an example, the substrate 100 may be a P-type substrate, and the thickness of the substrate 100 can be adjusted as needed. An epitaxial layer may or may not be formed on the substrate 100. When an epitaxial layer is present on the substrate 100, the epitaxial layer may be either P-type or N-type, and the active region 110 may be formed on the epitaxial layer.

The main portion of the active region 110 may be an N-type well (NWELL), which can be formed by doping N-type impurities into the substrate 100. The source region 111 and the drain region 112 may be formed by doping upper portions of the substrate 100, with ion doping concentrations of the source region 111 and drain region 112 being higher than that of the active region 110.

As an example, the gate trench 113 can be formed using thermal processing and advanced etching techniques, including anisotropic, isotropic, or a combination of both etching methods in varying proportions. The gate trench 113 is recessed from the upper surface of the substrate 100 to the active region 110, that is, an opening of the gate trench 113 is located on the upper surface of the substrate 100. The perimeter of the gate trench 113 restricts the length of the drift region between the source region 111 and the drain region 112, thereby ensuring the BV of the power semiconductor device. At a target BV, the lateral dimension of the power semiconductor device is reduced while reducing the Rsp of the power semiconductor device. The width of the gate trench 113 can be linearly scaled down as the process node advances. The width, depth, and perimeter design of the gate trench 113 depends on achieving the optimal trade-off between BV and Rsp within the constraints of minimal area.

Optionally, the insulating layer 230 may include a gate oxide, the main gate 210 may include a polysilicon or a conductive metal deposited on the gate oxide. The gate oxide is in contact with the source region. A thickness of the gate oxide may be adjusted as needed; for example, it may range from 20 angstroms to 400 angstroms. The main gate 210 extends downward from the upper surface of the gate trench 113, that is, a top end of the main gate 210 is located on the upper surface of the gate trench 113. The top end of the main gate 210 can be connected to an external circuit.

As an example, the insulating layer 230 can be made of silicon dioxide. A dielectric constant of the insulating layer 230 is greater than a dielectric constant of the substrate 100 (i.e., bulk silicon), and under the same withstand voltage requirement, the required width of the insulating layer 230 is smaller than that of the bulk silicon. The main gate 210 is arranged at a location closer to the source region 111 than to the drain region 112, such that a thickness of the insulating layer 230 between the main gate 210 and the drain region 112 is relatively large, and the insulating layer 230 can withstand voltage.

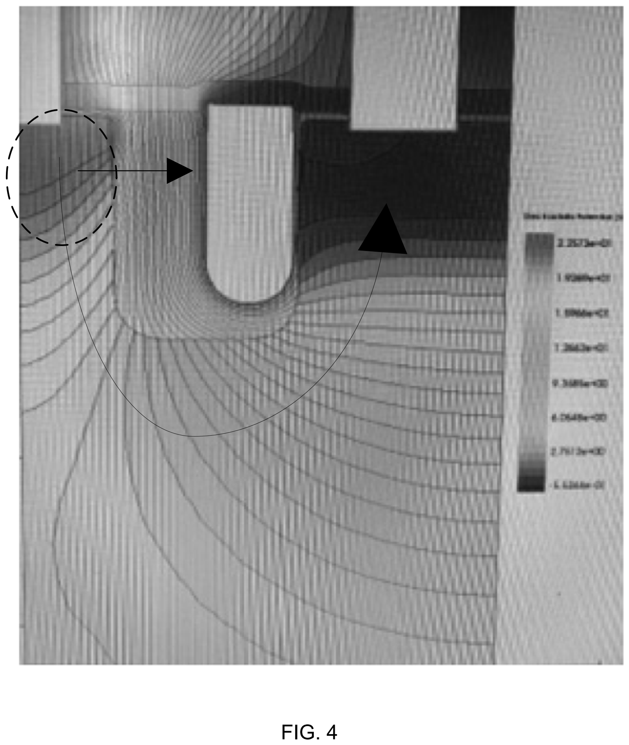

In the disclosed power semiconductor device, the gate trench 113 is formed between the source region 111 and the drain region 112 and is recessed from the upper surface of the substrate 100 to the active region 110. The main gate 210 is located in the gate trench 113, and the main gate 210 extends downward from the upper surface of the gate trench 113. The insulating layer 230 is formed between the inner wall of the gate trench 113 and the main gate 210. Compared to conventional power semiconductor devices, the drift region length is transformed from the lateral spacing between the source and drain regions to the perimeter of the gate trench. This structural shift reduces the device's lateral dimension while maintaining the target BV, lowering the specific on-resistance (Rsp), thereby resulting in an improved BV-to-Rsp trade-off and enabling a more compact device design. As illustrated in FIG. 4, the electric field gradually decreases along the direction of the arrow, while the region enclosed by the dashed lines exhibits the highest field intensity, the thick insulating layer filling the gate trench can withstand a lager electric field, thereby increasing the breakdown voltage of the device.

As shown in FIGs. 3 to 8, a cross section of the gate trench 113 is U-shaped, rectangular, or trapezoidal.

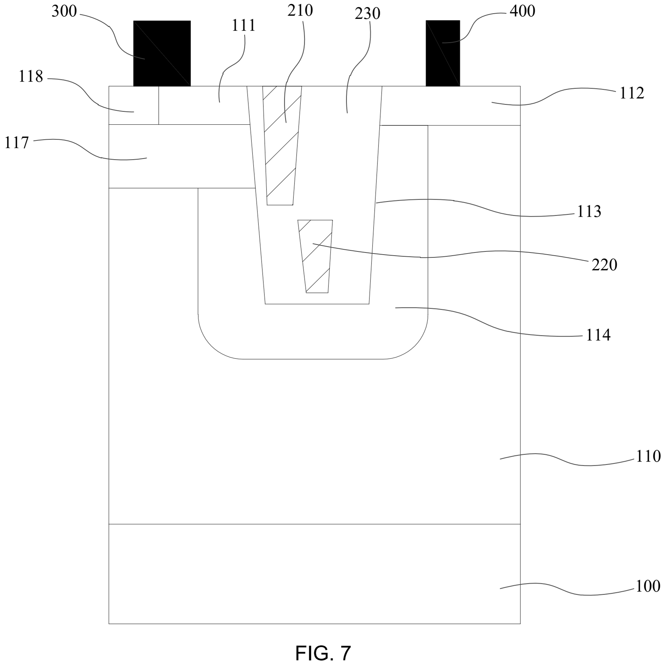

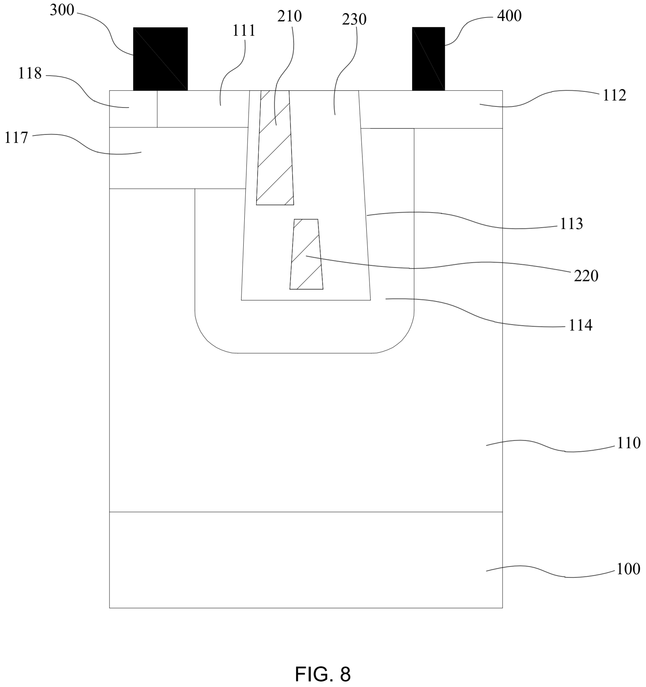

When the cross section of the gate trench 113 is U-shaped, the opening of the U-shaped gate trench 113 is located on the upper surface of the substrate 100. When the cross section of the gate trench 113 is trapezoidal, the opening of the trapezoid gate trench 113 is located on the upper surface of the substrate 100. As an example, as shown in FIG. 7, the opening of the trapezoid gate trench 113 corresponds to the top base of the trapezoid, and the length of the top base may be greater than the length of the bottom base of the trapezoid. In another embodiment, as shown in FIG. 8, the length of the top base may instead be smaller than the length of the bottom base. Through the above arrangements, the effective length of the drift region is extended.

As shown in FIGs. 3 to 8, the main gate 210 is arranged at a location closer to the source region 111 than to the drain region 112.

That is, the distance between the main gate 210 and the source region 111 is smaller than the distance between the main gate 210 and the drain region 112. The inner wall of the gate trench 113 includes a first inner wall positioned closer to the source region 111 and a second inner wall positioned closer to the drain region 112. The distance between the main gate 210 and the second inner wall of the gate trench 113, referred to as Distance A, can be adjusted as needed.

Disposing the main gate 210 closer to the source region 111 can better control the current flow from the source region 111 to the drain region 112, which helps to improve the control of carrier transmission in the channel, thereby improving the switching characteristics and reducing the on-resistance. The main gate 210 is positioned closer to the source region 111, which may help reduce parasitic capacitance between the main gate 210 and the drain region 112 to some extent.

As an example, as shown in FIGs. 3 to 8, the power semiconductor device further includes a source electrode 300 and a drain electrode 400. The source electrode 300 is disposed on the upper surface of the substrate 100 and electrically connected to the source region 111. The drain electrode 400 is disposed on the upper surface of the substrate 100 and electrically connected to the drain region 112.

As shown in FIG. 3, a bottom of the source electrode 300 is connected to the source region 111 to achieve electrical conduction between the source electrode 300 and the source region 111, and a bottom of the drain electrode 400 is connected to the drain region 112 to achieve electrical conduction between the drain 400 and the drain region 112. The power semiconductor device can be connected to the external circuit through the source 300 and the drain 400.

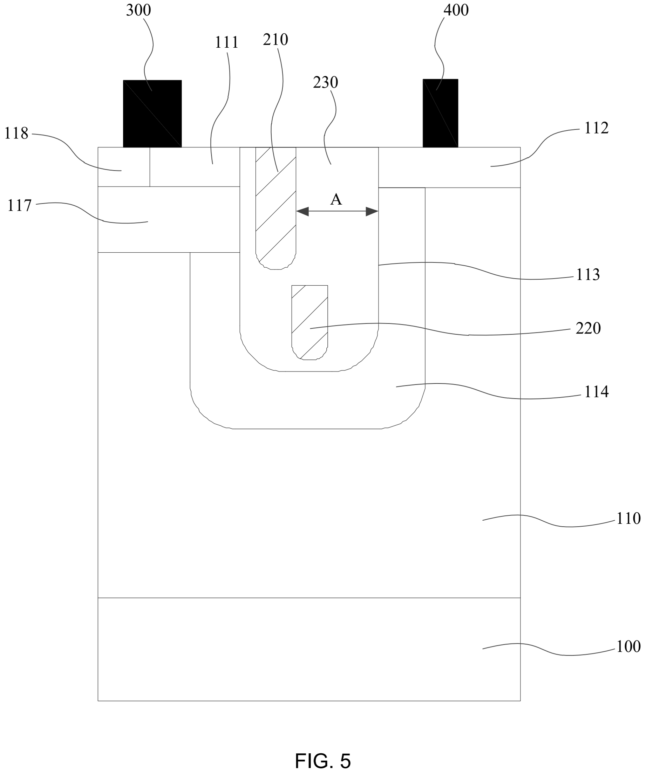

As an example, as shown in FIGs. 5 to 8, the power semiconductor device further includes at least one shielding gate 220, and the shielding gate 220 is disposed in the gate trench 113. The shielding gate 220 is disposed below the main gate 210, and the shielding gate 220 and the main gate 210 are spaced apart. The shielding gate 220 is disposed at a side of the main gate 210 closer to the drain region 112.

The main gate 210 is configured to control the channel of the power semiconductor device, while the shielding gate 220 is configured to shield the electric field generated by the high voltage at the drain 400. As an example, the main gate 210 and the shielding gate 220 are arranged in an interleaved manner, with the insulating layer 230 formed between them. Optionally, the shielding gate 220 can be made of conductive materials.

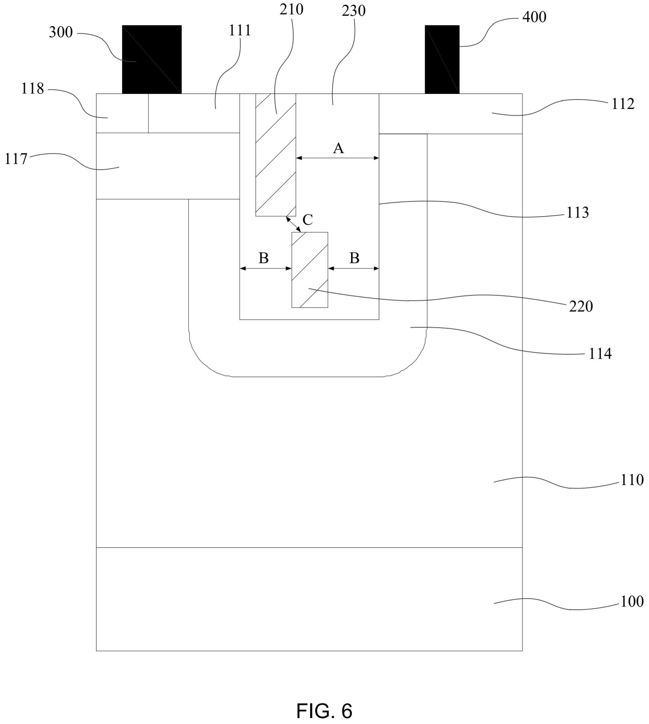

Those skilled in the art may adjust the BV of the power semiconductor device by modifying the respective depths of the main gate 210 and the shielding gate 220, as well as the spacing between the main gate 210 and the shielding gate 220 (i.e., adjusting Interval C as shown in FIG. 6). Optionally, contact holes are formed in the insulating layer 230, with the ends of the contact holes extending to the shielding gate 220, allowing the shielding gate 220 to be connected to an external potential through the contact holes.

The interleaved arrangement of the main gate 210 and the shielding gate 220 within the gate trench 113 enables voltage tunability of the power semiconductor device. Specifically, when the power semiconductor device is in an off state, the shielding gate 220 can be connected to a 0V potential; and when the power semiconductor device is in an on state, the shielding gate 220 can be connected to either a fixed 0V potential or a fixed potential greater than 0V, thereby reducing the device's Rsp.

Furthermore, the interleaved configuration of the main gate 210 and the shielding gate 220 within the gate trench 113 helps reduce capacitive coupling between the main gate 210 and the drain region 400. The shielding gate 220 modifies the electric field distribution around the main gate 210, thereby reducing the electric field intensity in the vicinity of the drain 400. As a result, the Gate-to-Drain Charge (Qgd) of the power semiconductor device is significantly reduced.

As another example, for low-rated-voltage semiconductor devices (e.g., those rated at 40V or below), the increased drift length along the perimeter of gate trench 113 results in a relatively shallow trench depth, at which time, the shielding gate 220 can be merged with the main gate 210, or omitted altogether depending on target application requirements.

As shown in FIGs. 5 to 8, the shielding gate 220 is spaced apart from the first inner wall of the gate trench 113 by a first spacing, and spaced apart from the second inner wall of the gate trench 113 by a second spacing. The first spacing is equal to the second spacing, both being represented as Spacing B in FIG. 6.

That is, in a width direction of the gate trench 113, the shielding gate 220 is located in the middle of the gate trench 113, and regions of the insulating layer 230 located on both sides of the shielding gate 220 can be used as voltage-withstanding regions. The first spacing and the second spacing can be adjusted according to the requirements of the shielding field regions. Optionally, in the manufacturing process of the power semiconductor device, the gate trench 113 is filled to form the insulating layer 230, a groove is provided in the middle area of the insulating layer 230, and the shielding gate 220 is formed in the groove.

Specifically, the shielding gate 220 is disposed in a middle position along the width direction of the gate trench 113, so that the groove is conveniently provided on the insulating layer 230, thereby facilitating the formation of the shielding gate 220 in the insulating layer 230, and improving the processing efficiency of the power semiconductor device.

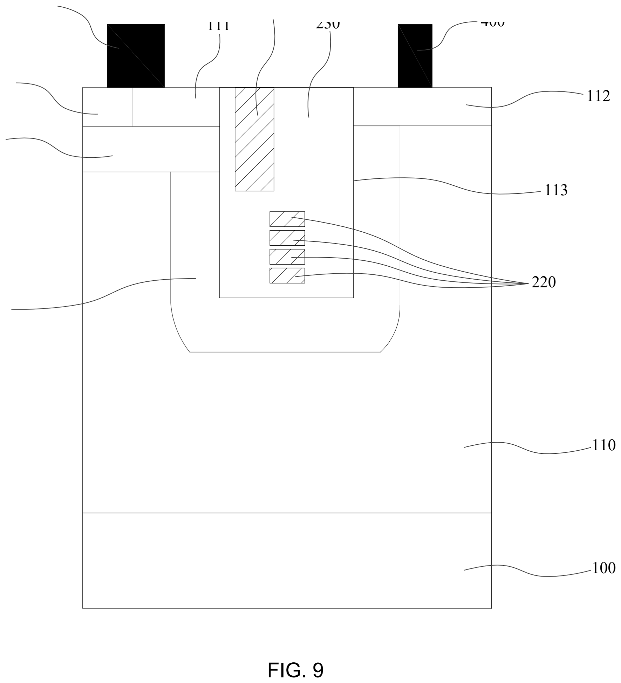

As an example, as shown in FIG. 9, the power semiconductor device includes two or more shielding gates 220, and the shielding gates 220 are arranged at intervals along a thickness direction of the substrate 100.

In the manufacturing process of the power semiconductor device, the length of each shielding gate 220 and the spacing between adjacent shielding gates 220 can be set according to the target BV and the gate-drain charges. The lengths of the shielding gates 220 may be the same or different. Each of the shielding gates 220 is disposed below the main gate 210, and situated on the side of the main gate 210 closer to the drain region 112.

Through the above arrangements, the universality of the power semiconductor device is enhanced, and the target BV and the gate-drain charges of the power semiconductor device can be selectively tuned by adjusting the quantity of the shielding gates 220, the length of each shielding gate 220, and the spacing between the adjacent shielding gates 220.

As shown in FIGs. 3 and 5-12, the active region 110 further includes a body region 117 of a second doping type, the body region 117 is located at a bottom of the source region 111, and a side edge of the body region 117 and a side edge of the source region 111 constitute part of the first inner wall of the gate trench 113. The gate oxide is in contact with the source region and body region 117.

Schematically, the ion doping types of the body region 117 and the source region 111 are different, and when the power semiconductor device is an NLDMOS, P-type impurities are doped in the body region 117; and when the power semiconductor device is a PLDMOS, N-type impurities are doped in the body region 117.

As an example, the active region 110 further includes a first doped region 114, and a first end of the first doped region 114 away from the drain region 112 is connected to the body region 117. As an example, the active region 110 further includes a second doped region 115, and a first end of the second doped region 115 away from the drain region 112 is connected to the body region 117. As an example, an ion doping concentration of the body region 117 is greater than an ion doping concentration of the second doped region 115.

As shown in FIGs. 3 and 5-12, the active region 110 further includes a body contact region 118, the body contact region 118 and the source region 111 are arranged side by side. Ion doping types of the body contact region 118 and the body region 117 are the same, and an ion doping concentration of the body contact region 118 is greater than the ion doping concentration of the body region 117.

As an example, as shown in FIGs.5 to 12, the first doped region 114 is of the first doping type, and the first doped region 114 surrounds sidewalls and a bottom of the gate trench 113.

Ion doping types of the source region 111, the drain region 112, and the first doped region 114 are the same; when the power semiconductor device is an NLDMOS, N-type impurities are doped in the first doped region 114; and when the power semiconductor device is a PLDMOS, P-type impurities are doped in the first doped region 114. The first doped region 114 can be formed by chain implantation. As an example, an ion doping concentration of the first doped region 114 is smaller than an ion doping concentration of the drain region 112 and greater than an ion doping concentration of the active region 110. Optionally, the first end of the first doped region 114 is electrically connected to the body contact region 118 through the body region 117.

As shown in FIGs. 5 to 12, the first doped region 114 forms a U-shaped region surrounding the gate trench 113, and a width of the first doped region 114 can be adjusted as required. It can be understood that the first doped region 114 constitutes at least part of the drift region.

By providing the first doped region 114, the ion doping concentration of the drift region between the source region 111 and the drain region 112 is increased, and the Rsp of the power semiconductor device is reduced.

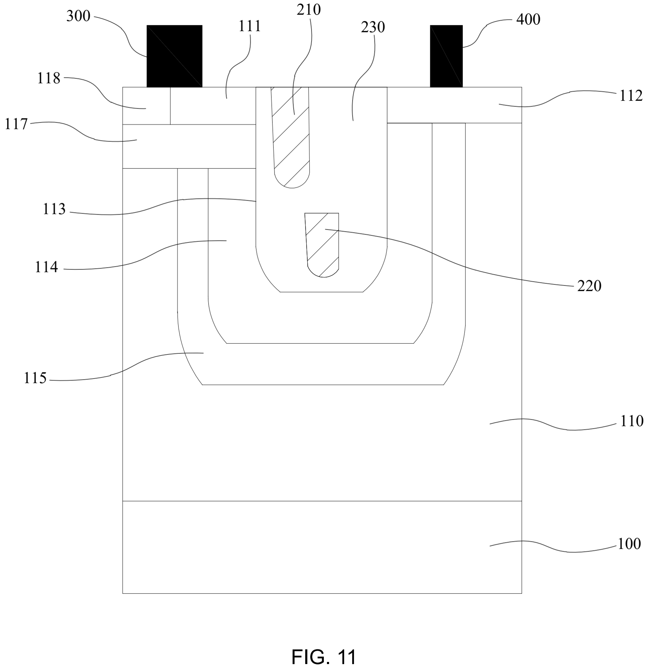

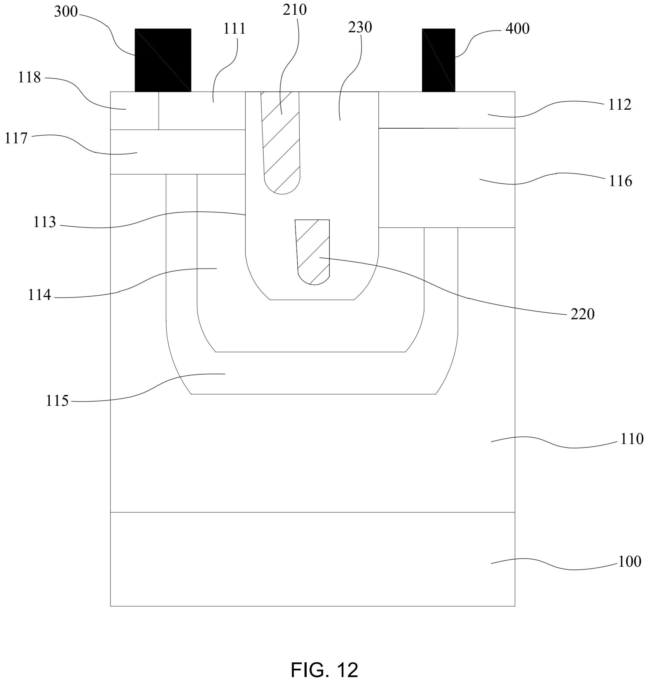

As an example, as shown in FIGs. 11 and 12, the second doped region 115 is of the second doping type, and the second doped region 115 surrounds a sidewall and a bottom of the first doped region 114.

Ion doping types of the first doped region 114 and the second doped region 115 are different. When the power semiconductor device is an NLDMOS, P-type impurities are doped in the second doped region 115; and when the power semiconductor device is a PLDMOS, N-type impurities are doped in the second doped region 115. The second doped region 115 can be formed by chain implantation. FIGs. 11 and 12 show that the first end of the second doped region 115 is electrically connected to the body contact region 118 through the body region 117.

As shown in FIGs. 11 and 12, the second doped region 115 forms a U-shaped region surrounding the first doped region 114, and a width of the second doped region 115 can be adjusted as required.

By disposing the second doped region 115, the second doped region 115 and the first doped region 114 can be mutually depleted, and the power semiconductor device can implement dual reduced-surface-field (RESURF) and increase BV of the power semiconductor device.

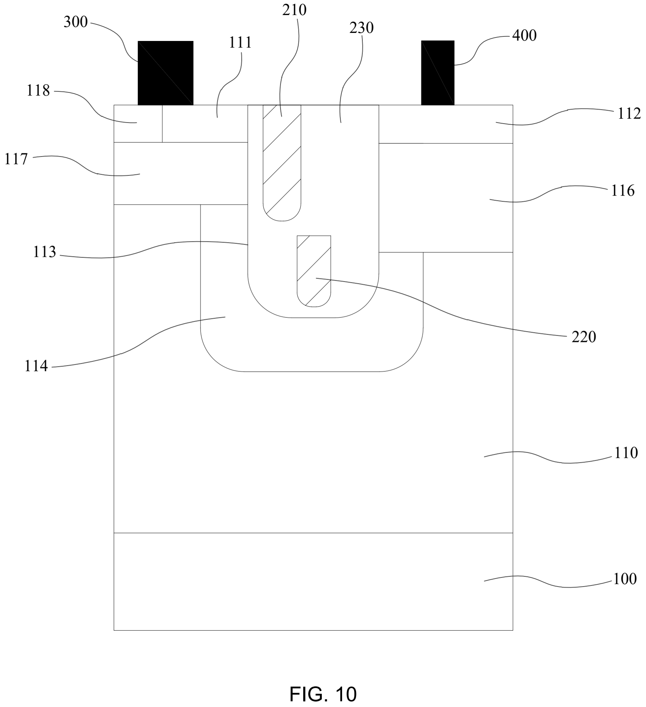

As an example, as shown in FIGs. 10 and 12, the active region 110 further comprises a heavily doped buffer region 116 of the first doping type. The heavily doped buffer region 116 is located at a bottom of the drain region 112, and an ion doping concentration of the heavily doped buffer region 116 is lower than the ion doping concentration of the drain region 112.

Schematically, the heavily doped buffer region 116 can form a drain drift region by doping ion implantation and/or thermal diffusion, and for the NLDMOS, an N-type drain drift region (NDD) is formed. FIGs. 10 and 12 illustrate that a side surface of the heavily doped buffer region 116 can be contact with the gate trench 113. The depth of the heavily doped buffer region 116 can be adjusted as needed.

As an example, a second end of the first doped region 114 and/or a second end of the second doped region 115 can be connected to a bottom of the heavily doped buffer region 116.

By providing the heavily doped buffer region 116, when the power semiconductor device bears a high voltage, a relatively uniform electric field distribution can be formed in the heavily doped buffer region 116, thereby mitigating the risk of breakdown due to electric field concentration. Furthermore, the heavily doped buffer region 116 possesses reduced resistivity, thereby decreasing the impedance encountered by the current of the drain 400 along the internal conduction path of the power semiconductor device and contributing to a reduction in the device's Rsp.

As an example, the body region 117 can form a PN junction with the active region 110 and/or with the first doped region 114. The side edge of the body region 117 and the side edge of the source region 111 constitute part of the first inner wall of the gate trench 113, such that when the power semiconductor device is forward biased, the accumulated charge in the PN junction is confined along the sidewall of the gate trench 113. Additionally, both the distance between the gate trenches 113, and the width of the gate trenches 113, are smaller than the distance between the source 300 and the drain 400 in conventional power semiconductor devices. This configuration restricts carrier movement to a narrower drift region, thereby facilitating efficient carrier recombination during reverse recovery and resulting in a reduced Reverse Recovery Charge (Qrr). For low Qrr power semiconductor devices, reverse recovery current can be reduced and switching power losses can be reduced. When the active region 110 comprises the first doped region 114 and the side edge of the body region 117 constitutes part of the sidewall of the gate trench 113, the area occupied by the PN junction is limited to the region of the bottom of the body region 117 connected to the first doped region 114, and the area of the PN junction can be narrowed due to the scaling of the advanced process node, which may further reduce the reverse recovery current and reduce the switching power losses.

It can be understood that a channel can be formed at the side edge of the body region 117 facing the gate trench 113, resulting in a vertical or quasi-longitudinal channel structure within the power semiconductor device, which reduces the lateral dimensions of the device, thereby allowing for a smaller cell pitch and improved integration density.

It is worth noting that the channel of the power semiconductor device disclosed herein can be precisely controlled. Specifically, by employing advanced process implantation tools such as an injection platform compatible with a 55 nm process node, utilizing longitudinal ion implantation, and leveraging the implantation energy differential between the body region 117 and the source region 111, the ion implantation energy along the longitudinal direction can be accurately regulated. Compared with the existing body region and source region formed through double diffusion, the channel can be effectively shortened. The power semiconductor device may exhibit a lower gate-to-source charge (Qgs) and a reduced channel length, thereby enhancing its suitability for operation at high frequencies.

The present disclosure further provides a method for manufacturing a power semiconductor device, comprising:

providing a substrate 100, wherein as an example, the substrate 100 can be a P-type substrate or an N-type substrate, and an epitaxial layer may or may not be formed on the substrate 100;

forming an active region 110 in the substrate 100, wherein as an example, the active region 110 is formed by ion implantation;

recessing an upper surface of the substrate 100 to the active region 110 to form a gate trench 113, wherein as an example, the gate trench 113 can be formed in the substrate 100 by heat treatment and/or etching process;

filling the gate trench 113 to form an insulating layer 230, wherein as an example, a material of the insulating layer 230 can be silicon dioxide;

forming a main gate 210 in the insulating layer 230, wherein as an example, the main gate 210 extends from an upper surface of the gate trench 113 into an interior of the gate trench 113, wherein as an example, after the insulating layer 230 is formed, a part of the insulating layer 230 is removed by photolithography to form a groove, that is, an opening of the groove is located on the upper surface of the substrate 100, and the main gate 210 is formed in the groove and situated on the side of the gate trench 113 closer to the source region 111;

forming a source region 111 and a drain region 112 on an upper surface of the active region 110, wherein as an example, the gate trench 113 is disposed between the source region 111 and the drain region 112, wherein as an example, the source region 111 and the drain region 112 can be formed by ion implantation process or ion implantation heating diffusion process, respectively, and the ion doping concentrations of the source region 111 and the drain region 112 are respectively greater than the ion doping concentration of the active region 110.

Compared to conventional power semiconductor devices, the drift region length is transformed from the lateral spacing between the source and drain regions to the perimeter of the gate trench. This structural shift reduces the device's lateral dimension while maintaining the target BV, lowering the specific on-resistance (Rsp), thereby resulting in an improved BV-to-Rsp trade-off and enabling a more compact device design.

As an example, before forming the main gate 210 in the insulating layer 230, the method further comprises: forming at least one shielding gate 220 in the insulating layer 230.

The shielding gate 220 is disposed below the main gate 210, and the shielding gate 220 and the main gate 210 are spaced apart. The shielding gate 220 is disposed at a side of the main gate 210 closer to the drain region 112.

As an example, a portion of the insulating layer 230 is formed by partially filing the gate trench 113. A first groove is then formed within the portion of the insulating layer 230, and the shielding gate 220 is formed in the first groove. After the shielding gate 220 is formed, the remaining portion of the gate trench 113 is further filled to form an additional section of the insulating layer 230. A second groove is subsequently formed in this newly added portion of the insulating layer 230, and the main gate 210 is formed within the second groove.

The interleaved arrangement of the main gate 210 and the shielding gate 220 within the gate trench 113 enables voltage tunability of the power semiconductor device, while also contributing to a reduction in the device's Qgd.

As an example, the main gate 210 is arranged at a location closer to the source region 111 than to the drain region 112.

Specifically, the inner wall of the gate trench 113 includes a first inner wall positioned closer to the source region 111 and a second inner wall positioned closer to the drain region 112. Distance A between the main gate 210 and the second inner wall of the gate trench 113 is greater than the distance between the main gate 210 and the first inner wall of the gate trench 113.

Distance A can be determined according to the requirements of the device electric field distribution, the second groove is determined based on Distance A, and then the main gate 210 is formed within the second groove.

Within the gate trench 113, the main gate 210 is positioned closer to the source region 111 than to the drain region 112, which may enhance switching characteristics, reduce on-resistance, and help minimize parasitic capacitance between the main gate 210 and the drain region 112.

As an example, the method further comprises: forming a source electrode 300 on the upper surface of the substrate 100. The source electrode 300 is electrically connected to the source region 111. As an example, the method further comprises: forming a drain electrode 400 on the upper surface of the substrate 100. The drain electrode 400 is electrically connected to the drain region 112.

As an example, a first metal layer is deposited at a position corresponding to the source region 111 on the upper surface of the substrate 100 as the source electrode 300, a second metal layer is deposited at a position corresponding to the drain region 112 on the upper surface of the substrate 100 as the drain electrode 400. The source electrode 300 is electrically connected to the source region 111, and the drain electrode 400 is electrically connected to the drain region 112. The power semiconductor device can be connected to the external circuit through the source electrode 300 and the drain electrode 400.

As an example, after forming the gate trench 113 and before forming the source region 111 and the drain region 112, the method further includes: forming a first doped region 114 in the active region 110, the first doped region 114 surrounds sidewalls and a bottom of the gate trench 113. An ion doping concentration of the first doped region 114 is greater than an ion doping concentration of the active region 110. The active region 110 is of the first doping type.

The first doped region 114 can be formed by chain implantation, and the first doped region 114 is connected to the source region 111 and the drain region 112, respectively.

By providing the first doped region 114, the ion doping concentration of the drift region between the source region 111 and the drain region 112 is increased, and the Rsp of the power semiconductor device is reduced.

As an example, before forming the first doped region 114, the method further comprises: forming a second doped region 115 in the active region 110. The second doped region 115 surrounds sidewalls and a bottom of the first doped region 114. Ion doping types of the first doped region 114 and the second doped region 115 are different. The second doped region 115 enhances the ion doping concentration of the first doped region 114, resulting in a first doped region 114 with increased ion doping concentration. Specifically, because the second doped region 115 is formed prior to the formation of the first doped region 114, the ion doping concentration of the first doped region 114 that incorporates the second doped region 115 is greater than that of a first doped region 114 formed without the second doped region 115.

The second doped region 115 can be formed by chain implantation, and after the formation of the second doped region 115, the chain implantation is performed again to form the first doped region 114. Ion doping types of the first doped region 114 and the second doped region 114 are different. The second doped region 115 surrounds the sidewalls and the bottom of the first doped region 114.

By disposing the second doped region 115, the second doped region 115 and the first doped region 114 can be mutually depleted, and the power semiconductor device can implement dual RESURF and increase BV of the power semiconductor device.

As an example, the method further includes: forming a heavily doped buffer region 116 in the active region 110. An ion doping concentration of the heavily doped buffer region 116 is lower than an ion doping concentration of the drain region 112, and the drain region 112 is disposed in the heavily doped buffer region 116.

Optionally, the heavily doped buffer region 116 can be formed by ion implantation process or ion implantation heating diffusion process. Ion doping types of the heavily doped buffer region 116 and the drain region 112 are the same. After the drain region 112 is formed in the active region 110, the ion doping concentration of the heavily doped buffer region 116 is lower than the ion doping concentration of the drain region 112.

By providing the heavily doped buffer region 116, when the power semiconductor device bears a high voltage, a relatively uniform electric field distribution can be formed in the heavily doped buffer region 116, thereby mitigating the risk of breakdown due to electric field concentration. Furthermore, the heavily doped buffer region 116 possesses reduced resistivity, thereby decreasing the impedance encountered by the current of the drain 400 along the internal conduction path of the power semiconductor device and contributing to a reduction in the device's Rsp.

As an example, the method further includes: forming a body region 117 in the active region 110. The body region 117 is located at a bottom of the source region 111, and a side edge of the body region 117 and a side edge of the source region 111 constitute part of a first inner wall of the gate trench 113 positioned closer to the source region 111.

The body region 117 can be formed by ion implantation or ion implantation heating diffusion. After the gate trench 113 is formed in the substrate 100, the sidewall of the gate trench 113 is connected to the body region 117 and the source region 111, respectively, so that the side edge of the body region 117 and the side edge of the source region 111 constitute said part of the sidewall of the gate trench 113 positioned closer to the source region 111. When the power semiconductor device is provided with the second doped region 115, an ion doping concentration of the body region 117 can be greater than an ion doping concentration of the second doped region 115.

As an example, a PN junction can be formed between the body region 117 and the active region 110, and/or between the body region 117 and the first doped region 114. The side edge of the body region 117 and the side edge of the source region 111 constitute part of the first inner wall of the gate trench 113, such that when the power semiconductor device is forward biased, the accumulated charge in the PN junction is confined along the sidewall of the gate trench 113. Additionally, both the distance between the device and the gate trench 113, and the width of the gate trench 113, are smaller than the distance between the source 300 and the drain 400 in conventional power semiconductor devices. This configuration restricts carrier movement to a narrower drift region, thereby facilitating efficient carrier recombination during reverse recovery and resulting in a reduced Qrr. For low Qrr power semiconductor devices, reverse recovery current can be reduced and switching power losses can be reduced. When the active region 110 comprises the first doped region 114 and the side edge of the body region 117 constitutes part of the sidewall of the gate trench 113, the area occupied by the PN junction is limited to the region of the bottom of the body region 117 connected to the first doped region 114, and the area of the PN junction can be narrowed due to the scaling of the advanced process node, which may further reduce the reverse recovery current and reduce the switching power losses. A channel can be formed at the side edge of the body region 117 facing the gate trench 113, resulting in a vertical or quasi-longitudinal channel structure within the power semiconductor device, which enables a reduction in the lateral dimensions of the device, thereby allowing for a smaller cell pitch and improved integration density.

In a specific embodiment, the body region 117 is formed by ion implantation or ion implantation heating diffusion, and a gate-to-source charge of the power semiconductor device is reduced by adjusting a depth of the body region 117 disposed below the source region 111.

As an example, the body region 117 is formed by ion implantation using an injection platform compatible with a 55 nm process node, thereby achieving enhanced control precision. The depth of the body region 117 can be precisely controlled, allowing the overlap area between the gate trench 113 and the body region 117 beyond the source region 111 to be adjustable. This arrangement enables the Qgs and the channel of the power semiconductor device to be minimized, thereby facilitating optimal performance of the device at high frequencies.

Finally, it should be noted that the above embodiments are only used to illustrate the technical schemes of the present disclosure without limitation. Although the present disclosure is described in detail with reference to the foregoing embodiments, a person of ordinary skill in the art should understand that the technical solutions described in the foregoing embodiments can still be modified, or some or all of the technical features can be equivalently replaced; and these modifications or replacements do not make the essence of the corresponding technical solutions fall within the scope of the technical solutions of the embodiments of the present disclosure.

## Claims

1. A power semiconductor device, comprising:
a substrate (100), wherein the substrate (100) comprises an active region (110), the active region (110) comprises a source region (111) and a drain region (112), both of which are of a first doping type and extend from an upper surface of the substrate (100) into its interior, wherein a gate trench (113) is formed between the source region (111) and the drain region (112) and is recessed from the upper surface of the substrate (100) to the active region (110);
a main gate (210) located in the gate trench (113), wherein the main gate (210) extends downward from an upper surface of the gate trench (113); and
an insulating layer (230), formed between an inner wall of the gate trench (113) and the main gate.

2. The power semiconductor device according to claim 1, wherein the main gate (210) is arranged at a location closer to the source region (111) than to the drain region (112).

3. The power semiconductor device according to claim 1, further comprising:
a source electrode (300), disposed on the upper surface of the substrate (100) and electrically connected to the source region (111); and
a drain electrode (400), disposed on the upper surface of the substrate (100) and electrically connected to the drain region (112).

4. The power semiconductor device according to claim 1, further comprising at least one shielding gate (220), wherein the shielding gate (220) is disposed in the gate trench (113);
wherein the shielding gate (220) is disposed below the main gate (210), wherein the shielding gate (220) and the main gate (210) are spaced apart;
wherein the shielding gate (220) is disposed at a side of the main gate (210) closer to the drain region (112).

5. The power semiconductor device according to claim 4, wherein the inner wall of the gate trench (113) comprises a first inner wall positioned closer to the source region (111) and a second inner wall positioned closer to the drain region (112), and the shielding gate (220) is spaced apart from the first inner wall by a first spacing, and spaced apart from the second inner wall by a second spacing;
wherein the first spacing is basically equal to the second spacing.

6. The power semiconductor device according to claim 4, wherein the power semiconductor device comprises two or more shielding gates (220), and the shielding gates (220) are arranged at intervals along a thickness direction of the substrate (100).

7. The power semiconductor device according to claim 1, wherein the active region (110) further comprises a first doped region (114) of the first doping type, and the first doped region (114) surrounds sidewalls and a bottom of the gate trench (113).

8. The power semiconductor device according to claim 1, wherein the active region (110) further comprises a heavily doped buffer region (116) of the first doping type, the heavily doped buffer region (116) is located at a bottom of the drain region (112), and an ion doping concentration of the heavily doped buffer region (116) is lower than an ion doping concentration of the drain region (112).

9. The power semiconductor device according to claim 1, wherein the active region (110) further comprises a body region (117) of a second doping type, the body region (117) is located at a bottom of the source region (111), and a side edge of the body region (117) and a side edge of the source region (111) constitute part of the first inner wall of the gate trench (113).

10. A method for manufacturing a power semiconductor device, comprising:
providing a substrate (100);
forming an active region (110) in the substrate (100);
recessing an upper surface of the substrate (100) to the active region (110) to form a gate trench (113);
filling the gate trench (113) to form an insulating layer (230);
forming a main gate (210) in the insulating layer (230), wherein the main gate (210) extends from an upper surface of the gate trench (113) into an interior of the gate trench (113); and
forming a source region (111) and a drain region (112) extending from an upper surface of the active region (110) into its interior, wherein the gate trench (113) is disposed between the source region (111) and the drain region (112).

11. The method according to claim 10, before forming the main gate (210) in the insulating layer (230), the method further comprises:
forming at least one shielding gate (220) in the insulating layer (230),
wherein the shielding gate (220) is disposed below the main gate (210), and the shielding gate (220) and the main gate (210) are spaced apart, and
wherein the shielding gate (220) is disposed at a side of the main gate (210) closer to the drain region (112).

12. The method according to claim 10, wherein the main gate (210) is arranged at a location closer to the source region (111) than to the drain region (112).

13. The method according to claim 10, further comprising:
forming a source electrode (300) on the upper surface of the substrate (100), wherein the source electrode (300) is electrically connected to the source region (111); and
forming a drain electrode (400) on the upper surface of the substrate (100), wherein the drain electrode (400) is electrically connected to the drain region (112).

14. The method according to claim 10, further comprising:
forming a heavily doped buffer region (116) in the active region (110), wherein an ion doping concentration of the heavily doped buffer region (116) is lower than an ion doping concentration of the drain region (112), and the drain region (112) is disposed in the heavily doped buffer region (116).

15. The method according to claim 10, further comprising:
forming a body region (117) in the active region (110), wherein the body region (117) is located at a bottom of the source region (111), and a side edge of the body region (117) and a side edge of the source region (111) constitute part of a first inner wall of the gate trench (113) positioned closer to the source region (111).
